# DEMANDE DE BREVET EUROPEEN

(11) **EP 1 659 592 A1**
(43) Date de publication de la demande: **24.05.2006**
(21) Numéro de dépôt: 04105839.7
(22) Date de dépôt: 17.11.2004
(51) Int. Cl.: G11C 7/24, G11C 7/10, G06F 11/10, G11C 16/26

(54) **Procédé d'accès à une mémoire avec détection d'erreur à la base d'un code d'erreur contenant le nombre de bits d'un mot de donnée ayant la même valeur logique, et dispositif correspondant**

(71) Demandeur: Semtech Neuchâtel SA, 2000 Neuchâtel (CH)
(72) Inventeur: Chevroulet, Michel, 2000 Neuchâtel (CH); De Geeter, Bart, 2000 Neuchâtel (CH)
(74) Mandataire: P&TS Patents & Technology Surveys SA

(57) **Abrégé**

Une mémoire ROM ou flash à faible consommation d'énergie comprend des données de contrôle utilisées pour garder une information sur le nombre de bits de données qui ne changent pas par rapport à un état initial. La méthode proposée permet une détermination sûre de la fin d'une opération de lecture, même sous l'effet de facteurs externes variables. Les amplificateurs de sortie de la mémoire peuvent être arrêtés dès qu'ils ne sont plus utilisés pour réduire la consommation.

## Description

### Domaine technique

La présente invention concerne un procédé d'accès à une mémoire et le dispositif correspondant, et notamment, maispas exclusivement, un procédé de lecture pour une mémoire flash, ROM ou DRAM pour un microcontrôleur à faible consommation, ainsi que le microcontrôleur et le module de mémoire implémentant un tel procédé.

### Etat de la technique

Leséquipement électroniques modernes se basent toujoursplus sur l'emploi de mémoires numériques à état solide, par exemple des mémoires RAM, DRAM, Rash ou ROM, pour stocker des éléments d'information, tels que desdonnéesou desinstructionsde programme. De telles mémoires sont disponiblessousforme de composantsélectroniques, ou sousforme de modules de circuit intégrés dans des dispositifs plus complexes, par exemple dansdes microcontrôleur ou dans des systèmes à microprocesseur.

Lorsde la lecture d'une position de mémoire, les données sont transféréesau registre de lecture de la mémoire avec une vitesse qui n'est pas la même pour tous les bits, ni pour tous lesdispositifs. Le contenu du registre de lecture présente donc une période transitoire pendant laquelle son contenu est erroné avant de se stabiliser à la valeur requise.

La vitesse de transfert peut aussi dépendre de facteursexternes variables, par exemple de la température et de la tension d'alimentation.

Pour éviter deserreursde lecture il est courant d'introduire, entre l'adressage de la mémoire et la lecture du registre, un temps d'attente fixe suffisamment long pour que tous lesbitsdu registre de lecture se stabilisent. Pour accommoder les tolérances et lesvariationsdu tempsde réponse, ce temps d'attente comprend nécessairement une marge de sécurité importante. Il va de soi que ce tempsd'attente a des conséquences néfastes sur la vitesse de traitement et sur la consommation électrique.

La consommation énergétique des mémoires, par exemple des mémoiresde type flash, est principalement constituée par la consommation des amplificateurs de sortie. Ces amplificateurs doivent être rapides pour que le circuit puisse travailler rapidement, maissont normalement arrêtés aprèsavoir lu un mot de mémoire. Afin de minimiser le tempsd'attente et le rapport cyclique d'utilisation des amplificateurs, il a été proposé d'utiliser un ou plusieursbitsde parité pour chaque mot de mémoire pour générer un signal annonçant que la mémoire a été lue avec succès. Cette méthode évite destempsd'attente fixesinutilement long, mais elle ne permet pas d'exclure toutes les erreurs, car les valeurs des données et de la parité peuvent correspondre accidentellement durant la période transitoire.

Un autre inconvénient de cette approche est que le circuit requis pour la vérification de la parité est complexe et induit une consommation énergétique supplémentaire.

### Divulgation de l'invention

Un but de la présente invention est de proposer une méthode d'accès à une mémoire exempte des limitations des méthodes connues. En particulier la présente invention a pour but de proposer une méthode d'accèsà une mémoire permettant de réduire le tempsd'attente.

Un autre but de l'invention est de proposer un circuit de mémoire et un microcontrôleur plus rapideset présentant une plusfaible consommation énergétique que les circuits et les dispositifs de l'art antérieur.

Ces buts sont atteintspar la méthode et par les dispositifs qui font l'objet des revendications indépendantes dans les catégories correspondantes, et notamment par une méthode d'accès à une mémoire, ladite mémoire comprenant une zone de stockage et des moyensde sortie pour sortir une information contenue dans ladite zone de stockage, la méthode comprenant lesétapesde :
- charger chaque bit desdits moyensde sortie avec une valeur initiale.
- transférer desdonnées numériquesde ladite zone de stockage auxdits moyens de sortie ;
- obtenir desdonnéesde contrôle exprimant le nombre de bits desditesdonnéesnumériquesqui sont identiquesà ladite valeur initiale;
- vérifier si lesdites données de contrôle correspondent au nombre de bits desdites données numériques dans lesdits moyensde sortie ayant ladite valeur initiale.

Lesbutsci-dessussont aussi atteintspar un dispositif de mémoire comprenant:
- une zone de stockage pour stocker desinformations numériques;
- des moyens de sortie pour sortir des données numériques contenues dans ladite zone de stockage, lesdits moyens de sortie étant chargésavec une valeur initiale avant chaque opération de lecture ;
- un dispositif de contrôle arrangé de manière à comparer le nombre de bits des dites données numériques dans lesdits moyens de sortie ayant ladite valeur initiale avec un code de contrôle exprimant le nombre attendu de bits desdites données numériquesayant ladite valeur initiale.

Les buts ci-dessus sont aussi atteintspar un microcontrôleur comprenant un dispositif de mémoire selon l'invention.

### Brève description des dessins

La présente invention sera mieux comprise à la lecture de la description donnée à titre d'exemple et illustrée par les figures annexées dans lesquelles :
La figure 1 représente la structure d'une mémoire organisée en m mots de n bits ;
La figure 2 représente une structure possible d'une position de mémoire comprenant des bitsde contrôle selon l'invention ;
Le chronogramme de la figure 3 représente schématiquement l'évolution des signaux lorsd'un accèsà la mémoire selon la méthode de l'invention.

### Mode(s) de réalisation de l'invention

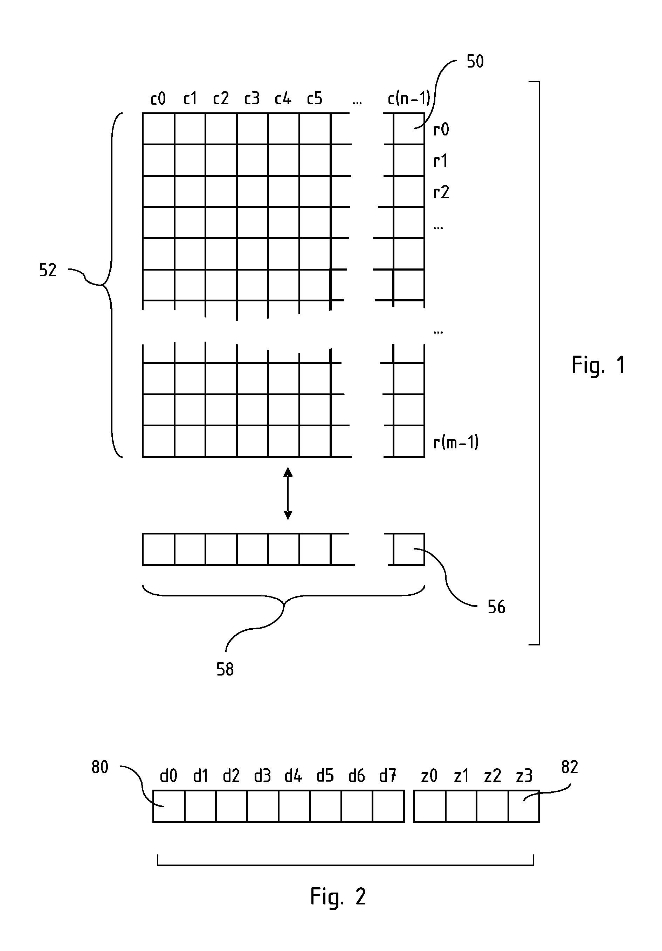

La figure 1 représente une mémoire de type connu, organisée selon une matrice de m lignes 52 et n colonnes58. Chacune des lignes correspond à une position de mémoire de n bits. Lorsde la lecture d'un mot de la mémoire, une adresse de 0 à m-1 est écrite dans un registre non représenté, par exemple, et le contenu de la ligne de mémoire correspondante est transféré au registre de sortie 56. En général la mémoire fera partie d'un circuit complexe non représenté, par exemple d'un système à microcontrôleur.

Cette méthode d'adressage est présentée à titre d'exemple uniquement, et l'invention comprend aussi plusieurs autres méthodes et variantes pour adresser le contenu d'une mémoire ROM ou RAM, qu'il serait fastidieux d'énumérer ici.

Au début d'une opération de lecture, le registre de sortie 56 est préchargé avec la même valeur binaire pour tous les bits, par exemple tous les bits à zéro ou tous les bits à 1.

Dansun castypique, mais pasexhaustif, la mémoire selon l'invention est une mémoire flash non volatile, ou une mémoire ROM programmable, destinée àstocker les instructionsde programme pour un système à microcontrôleur. Lesopérationsde lecture sont donc beaucoup plus fréquentes, pour ce type de mémoire, que lesopérationsd'écriture et leur impact sur la consommation énergétique est prépondérant.

La figure 2 représente une structure possible d'une position de mémoire selon l'invention. Une position de mémoire comprend un champ de données comprenant un nombre prédéterminé de bitsde données d0-d7 et un champ de contrôle comprenant un ou plus bitsde contrôle z0-z3. Danscet exemple, chaque mot comprend 8 bitsde données. II est toutefois évident que la présente invention peut être appliquée à une mémoire avec une nombre quelconque de bitsde donnéespar mot, par exemple 4, 16, 24, 22 ou 36 bits.

Les mémoires ROM ou flash sont habituellement lue par charge (ou décharge) de leurs colonnes, ou par un autre principe ayant les mêmes caractéristiques. Dans le casd'une mémoire lue par charge, les bits du registre de sortie sont tousdansun état initial zéro et passent dansun état désiré lors de la lecture. La charge est plus ou moins rapide sur différentes colonnes, maiselle est en général monotone, dans le sensqu'un "0" reste un "0" ou devient un "1", mais un "1" ne revient pasà l'état "0". Il n'y a donc pas, ou pratiquement pas, de glitch dans les bitsdu registre de sortie 56. (Analogiquement, dans le casd'une mémoire lue en décharge, la valeur initiale "1" des bits du registre de sortie 56 passe éventuellement à"0" aprèsun temps plusou moinsrapide, mais elle ne revient pasà " 1").

Selon un aspect de l'invention on code dans la mémoire, dans le champ de contrôle 82, le nombre de bitsqui doivent rester à zéro. Si le mot codé dans le champ de données est "01010000b" on aura ajouté, dans le champ de contrôle 82 le code "0110b" qui indique que 6 bitsdoivent être à zéro en fin de lecture.

Lorsque, dans le registre de sortie 56, le nombre de bitsà zéro dans le champ de données 80 correspond à la valeur du champ de contrôle 82, tous les bits du registre 56 ont atteint leur valeur définitive, et la mémoire est prête. Préférablement la mémoire délivre un signal V qui indique la correspondance entre le nombre de bitsà zéro dans le champ de données 80 et la valeur du champ de contrôle 82.

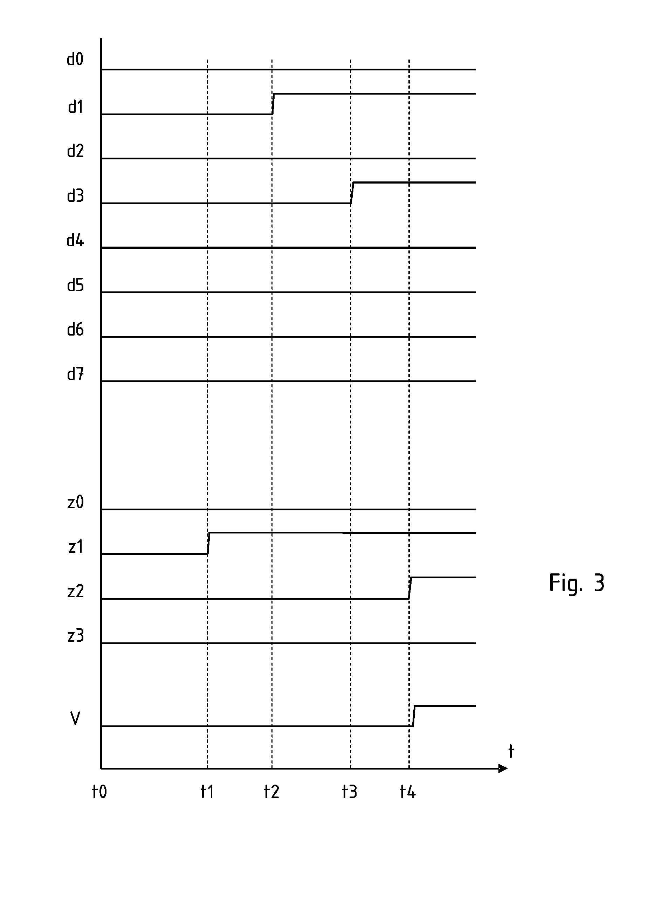

La figure 3 représente le chronogramme relatif au contenu des bitsd0-d7 et z0-z3 du registre de sortie, lorsd'une opération de lecture de mémoire selon l'invention. La position de mémoire adressée contient, par exemple, la valeur "01010000b" dans le champ de données 80 et la valeur "0110b" dans le champ de contrôle 82. A t = t0, tous les bits d0-d7 et z0-z3 sont à zéro. Il n'y a donc pas de correspondance entre la valeur du champ de données 80, avec 8 bitsà zéro, et le contenu du registre de contrôle 82, qui indique 0 bits à zéro. La valeur du signal V est donc à zéro.

A l'instant t=t1, le bit z1 passe à l'état haut, II y a donc un "2" dansle champ de contrôle 82, maistoujours 8 bitsà zéro dans le champ des données 80. Le signal V reste à zéro.

A l'instant t=t2 le bit d1 passe à l'état haut. II n'y a pas encore de correspondance entre le contenu du champ de contrôle (2) et le nombre de bitsà zéro du champ de données (7). Le signal V reste à zéro.

A l'instant t=t3 le bit d3 passe à l'état haut. II n'y a pas encore de correspondance entre le contenu du champ de contrôle (2) et le nombre de bitsà zéro du champ de données (6). Le signal V reste à zéro.

Finalement à t=t4 le bit z3 passe à l'état haut. Il y a correspondance entre le contenu du champ de contrôle (6) et le nombre de bitsà zéro du champ de données (6). Le signal V passe à " 1" pour signaler que la mémoire est prête.

Pour une mémoire lue en décharge on commence avec des" 1" dans tous les bits du registre 56 et on code dans la mémoire, dans le champ de contrôle 82, le nombre de bitsqui doivent rester à "1".

La technique de l'invention a l'avantage que la condition d'acceptation n'est jamais remplie tant que tous les bitsqui doivent changer de valeur ne l'ont pasfait. En effet le nombre de bitsà"0" dans le champ de donnéesdécroît de manière monotone, tandisque le contenu du champ de contrôle 82 croît de manière monotone.

La technique s'étend évidemment à un nombre de bitsarbitraire, avec la prescription que le champ de contrôle 82 doit être suffisamment grand pour contenir un nombre binaire correspondant au nombre de bits de donnéesdu champ de données80. Dans l'exemple illustré sur la figure 2, 4 bitsz0-z3 sont nécessairespour exprimer huit en binaire. Dansle cas d'une mémoire à 22 bits, un code de contrôle à 6 bitssera requis.

Le signal V indiquant la fin d'une opération de lecture pourra être utilisé par exemple pour réduire la consommation énergétique de la mémoire, par exemple en arrêtant les amplificateurs de sortie ou d'autres composants, lorsque leurs fonctionsne sont pas requises.

En outre le signal V peut être utilisé pour détecter des disfonctionnementsde la mémoire, par exemple si la mémoire n'est pas prête avant la prochaine instruction de la CPU, ou avant un temps maximal prédéterminé.

La génération du signal V selon l'invention peut être effectuée par des moyensde calcul internesà la mémoire elle-même, ou bien par un circuit externe.

La méthode de la présente invention peut aussi être implémentée par logiciel. Dansce cas, un processeur programmé à cet effet vérifie la correspondance deschampsde donnéeset de contrôle.

Si le dispositif de mémoire génère le signal V de manière autonome il n'est pas nécessaire que les bitsde contrôle 82 soient accessibles à l'extérieur de la mémoire. II est aussi préférable, dansce cas que le dispositif de mémoire comprenne des moyens autonomes pour générer lesbitsde contrôle 82 lorsd'une opération d'écriture.

L'exemple décrit ci-dessuscomporte une mémoire organisée de manière à pouvoir stocker, pour chaque adresse possible, à coté de chaque mot de données, le nombre de bitsà zéro (respectivement à 1 dans le cas d'une mémoire lue en décharge). Cependant on pourrait aussi réaliser, dans le cadre de la présente invention, des dispositifs dans lesquels le nombre de bitsà zéro n'est passtocké mais calculé à partir du contenu de la mémoire pour chaque opération de lecture.

La détection du tempsd'accèsde la mémoire est trèsimportante pour les systèmes dont la fréquence d'horloge est programmable (c'est le cas pour la majorité dessystèmesà microcontrôleur actuels). Le système peut ainsi déterminer si la fréquence d'horloge est trop rapide pour la mémoire, et compenser cette "survitesse" , par exemple en ajoutant des cycles d'attente ou en adaptant la cadence de l'horloge, afin de continuer à exécuter des instructions valides ou à lire des données correctes. Une interruption pourra éventuellement être générée afin que le logiciel puisse mettre en oeuvre les mesures appropriées pour gérer la situation, par exemple ralentir l'horloge, générer une exception, agir sur la tension d'alimentation ou tout autre mesure appropriée.

Un avantage de la présente invention est que le système à microcontrôleur équipé d'une mémoire à contrôle du temps d'accès selon l'invention peut s'adapter de manière autonome aux variationsde vitesse de la mémoire, par exemple aux variations liées aux fluctuationsde la température ou de la tension d'alimentation, tout en assurant toujoursune consommation énergétique optimale.

Enfin le même principe peut également servir au contrôle de l'écriture en mémoire, si la mémoire part du même état en écriture qu'en lecture.

## Revendications

1. Méthode d'accès à une mémoire, ladite mémoire comprenant une zone de stockage (50) et des moyensde sortie pour sortir une information contenue dans ladite zone de stockage (50), la méthode comprenant les étapes de :
- charger chaque bit desdits moyensde sortie avec une valeur initiale.
- transférer desdonnées numériquesde ladite zone de stockage (50) auxdits moyensde sortie (58);
- obtenir desdonnéesde contrôle exprimant le nombre de bits desditesdonnéesnumériquesqui sont identiquesà ladite valeur initiale;
- vérifier si lesdites données de contrôle correspondent au nombre de bits desdites données numériques dans lesdits moyens de sortie (58) ayant ladite valeur initiale.

2. Méthode selon la revendication 1, dans lequel lesdits moyens de sortie comprennent un registre de sortie (56) ayant un champ de données (80) et un champ de contrôle (82) et dans lequel lesdites données numériques sont transféréesde ladite zone de stockage audit champ de données (80) et danslequel lesdites données de contrôle sont transférées de ladite zone de stockage audit champ de contrôle (82).

3. Méthode selon l'une des revendications précédentes comprenant une étape de générer un signal de fin de lecture lorsque lesdites données de contrôle correspondent au nombre de bitsdesdites données numériquesdans lesdits moyensde sortie (58) ayant ladite valeur initiale.

4. Méthode selon l'une des revendications précédentes, ladite zone de stockage étant organisée en lignes adressables, chaque ligne pouvant contenir un mot de donnéeset ledit code de contrôle, lesdites donnéesde contrôle étant luesde la zone de stockage.

5. Méthode selon l'une des revendicationsde 1 à 3, comprenant une étape de calcul dudit code de contrôle.

6. Méthode selon l'une des revendications précédentes dans laquelle les transitions de bits desdits moyensde sortie sont monotones.

7. Dispositif de mémoire arrangé de manière à mettre en oeuvre la méthode d'accèsselon l'une des revendications précédentes.

8. Dispositif de mémoire comprenant:
- une zone de stockage (50) pour stocker desinformations numériques;
- des moyensde sortie pour sortir desdonnées numériques contenues dans ladite zone de stockage (50), lesdits moyensde sortie étant chargés avec une valeur initiale avant chaque opération de lecture ;
- un dispositif de contrôle arrangé de manière à comparer le nombre de bits desdites données numériquesdans lesdits moyensde sortie (58) ayant ladite valeur initiale avec un code de contrôle exprimant le nombre attendu de bitsdesditesdonnées numériques ayant ladite valeur initiale.

9. Dispositif selon la revendication précédente dans lequel ladite zone de stockage est organisée en lignes adressables, chaque ligne pouvant contenir un mot de donnéeset ledit code de contrôle.

10. Dispositif selon la revendication 8 dans lequel ledit code de contrôle est calculé pour chaque opération de lecture.

11. Dispositif selon l'une des revendications précédentes pouvant générer un signal de fin de lecture lorsque ledit code de contrôle correspond au nombre de bit desdites données numériques dans lesdites moyensde sortie (58) ayant ladite valeur initiale.

12. Dispositif selon l'une des revendications précédentes dans lequel les transitions de bits desdits moyensde sortie sont monotones.

13. Microcontrôleur comprenant un dispositif selon l'une des revendicationsde 8 à 12.

14. Microcontrôleur selon la revendication précédente arrangé de manière à s'adapter à la vitesse de lecture du dispositif de mémoire.
